# EUROPEAN PATENT SPECIFICATION

(11) **EP 1 595 312 B1**
(45) Date of publication and mention of the grant of the patent: **26.09.2007**
(21) Application number: 04712868.1
(22) Date of filing: 19.02.2004
(51) Int. Cl.: H01R 13/514, H05K 7/14, H01R 13/52

(54) **MODULAR ELECTRICAL DEVICE WITH IMPROVED SEAL**
MODULARE ELEKTRISCHE VORRICHTUNG MIT VERBESSERTER ABDICHTUNG
DISPOSITIF ELECTRIQUE MODULAIRE MUNI D'UN JOINT AMELIORE

(30) Priority: 20.02.2003 DE 20302844 U; 11.07.2003 DE 20310761 U; 17.11.2003 US 716081
(43) Date of publication of application: 16.11.2005
(73) Proprietor: Rockwell Automation Technologies, Inc., Mayfield Heights, OH 44124 (US); Weidmüller Interface GmbH & Co. KG, 32760 Detmold (DE)
(72) Inventor: SICHNER, Gregg, M., Mentor, OH 44060 (US); LOSTOSKI, Douglas, A., Richfield, OH 44286 (US); HAGER, Robert, J., Windsor, OH 44099 (US); KOZLOWSKI, Robert, A., Twinsburg, OH 44087 (US); WUNSCHE, Torsten, D-33818 Leopoldshohe (DE); PUSCHNER, Klaus, D-32756 Detmold (DE); HANNING, Walter, D-32758 Detmold (DE); HOING, Michael, D-32657 Lemgo (DE)
(74) Representative: Specht, Peter
(86) International application number: PCT/US2004/004956
(87) International publication number: WO 2004/075357

(56) References cited:
- EP-A- 0 481 806
- EP-A- 0 661 915
- EP-A- 1 018 788
- DE-A- 19 807 710
- DE-U- 8 017 060
- US-A- 4 842 540
- US-A- 6 039 592
- US-A1- 2002 182 942
- US-B1- 6 254 428

## Description

### Background

The present development relates to a modular electrical device and, more particularly, to a modular electrical device that is highly resistant to ingress of water, oil, debris, dirt and other contaminants encountered in manufacturing and other environments without use of a separate enclosure. As described herein, one application for a device formed in accordance with the present development is as a modular distributed input/output (I/O) assembly that forms a part of or is connected to an industrial automation control system. Those of ordinary skill in the art will recognize that the device has other applications, and it is not intended that the device be limited to use for any particular application.

In connection with industrial automation control systems and other electrical systems, it has been deemed desirable to provide electrical devices for transmission/input/output of data signals and/or power voltages that are distributed throughout a manufacturing, distribution or other facility and located directly on or adjacent machines performing manufacturing, distribution, inspection and/or other processes. It has also been found that, in certain cases, these electrical devices should be modular to allow for customization, re-configuration and repair/replacement as needed during installation or later. This modularity improves usability but can lead to ingress of water, oil, dirt, debris, and/or other contaminants into the device, with highly undesirable consequences. Furthermore, modular components can undesirably separate owing to vibration, impact, cable stresses or other external forces.

Certain modular electrical devices are housed within an enclosure that provides secure mounting and also protects the device from environmental contamination. Use of an enclosure is often not practicable due to space constraints, ease of installation/re-configuration/repair and/or other concerns.

Contamination-resistant modular electrical devices are known. One example is a distributed input/output (I/O) assembly available commercially from Rockwell Automation under the trademark 1798 FLEX Armor^{™}. I/O circuitry is packaged in I/O modules, and the I/O modules of an assembly plug into a common baseplate. The baseplates is available in sizes of 2, 4, 6, and 8 I/O module slots. An I/O adapter module and a field termination module plug into two slots of the baseplate. The baseplate holds the modules in place and provides the backplane for the assembly. No enclosure is required because each module is packaged in a sealed housing rated for IP65/67 and NEMA 4X (indoor/outdoor) and 6P. While the FLEX Armor^{™} I/O system has enjoyed widespread commercial success, certain modifications have been deemed desirable, at least for particular applications. For example, with the FLEX Armor^{™} system, the baseplates are available in units of 2, 4, 6 and 8 I/O modules. Also, to maintain the environmental ratings, all slots on the baseplate must be filled with either a live I/O module or a filler module.

Other modular electrical devices that are resistant to environmental contamination are known and available commercially from other sources. Some of these devices rely on conventional O-ring seals or other types of seals that provide only a single sealing dynamic at each sealing location, i.e., only radial/lateral sealing or only axial/compressive sealing. In certain cases, these seals are susceptible to leakage, especially when the modular components are subjected to vibration or other external forces such as lateral and/or axial separation forces. Other known devices utilize conventional O-rings seals or other seals that are positioned in a manner where they can be damaged or dislodged during handling, installation or during repair/replacement operations. Another drawback associated with some of these conventional modular electrical devices is that the seal is connected to or forms a part of the permanent components of the system, instead of the replaceable components. As such, use of a replacement component does not automatically result in use of a new seal. Known modular electrical devices have also been found to be sub-optimal insofar as operative mating of the components is concerned. Some require use of separate fasteners such as screws or the like which can be inconvenient and can lead to component damage if the fasteners are over-torqued. Other systems rely on a simple friction fit between components, and this can lead to unintended separation of the components such as when the components are mounted in an inverted position and/or in response to cable strain. Examples of known modular electrical devices can be found in the following documents: U.S. Patent No. 6,475,036; U.S. Patent Application Publication No. 2002/0182942, which shows the features of the preamble of claim 1; U.S. Patent No. 4,707,043; German Utility Model No. DE 29703367 U1; and, German Utility Model No. DE 29607525U1.

In light of the foregoing, it has been deemed desirable to provide a new and improved modular electrical device and/or module for same with improved sealing between components. It is the object of the invention to solve this problem.

### Summary

The problem is solved by the subject matter of claim 1. Preferred embodiments are the subject matter of the subclaims.

### Brief Description of the Drawings

The development comprises components and arrangements of components, preferred embodiments of which are disclosed herein and shown in the drawings that form a part hereof, wherein:
Fig. 1 is an isometric view of a modular electrical device formed in accordance with the present development;
FIG. 2 is similar to FIG. 1, with all removable modules thereof not shown to reveal the underlying base assembly;
FIGS. 3, 4 and 5 are isometric views of an adapter base component, an intermediate base component, and an end base component, respectively;
FIGS. 6, 7 and 8 are top plan, bottom plan and isometric views, respectively, of one example of a removable module component formed in accordance with the present development;
FIG. 9 is a sectional view as taken along line 9-9 of FIG. 6;
FIG. 10 is a side view showing a removable module separated from a portion of the base assembly to which it is adapted to be operatively mated;
FIG. 11 is an isometric view that shows the removable module and portion of the base assembly of FIG. 10;
FIG. 12 is similar to FIG. 4, but shows the intermediate base component with an upper surface thereof partially removed to reveal a coupling device formed in accordance with the present development;
FIG. 13 is a bottom plan view of the intermediate base component shown in FIG. 12;
FIG. 14 is a side view of a removable module mated with the coupling device of an intermediate or end base component, with portions in the foreground not shown and portions of the base component broken away for clarity;
FIG. 15 is an isometric view of a sliding lock member component that forms a part of the coupling device;
FIG. 16A and 16B diagrammatically illustrate use of the coupling device to eject a removable module in accordance with the present invention;
FIG. 17A is an isometric view of the inner housing portion of a removable module;
FIG. 17B is a sectional view as taken along line B-B of FIG. 17A;
FIG. 17C is similar to FIG. 17B but shows an isometric sectional view;
FIG. 18A is a top plan view of an alternative seal formed in accordance with the present development as operatively mounted to a base component;
FIG. 18B is a sectional view as taken along line B-B of FIG. 18A; and,
FIGS. 19A and 19B show a modular electrical device formed in accordance with an alternative embodiment of the present development.

### Detailed Description

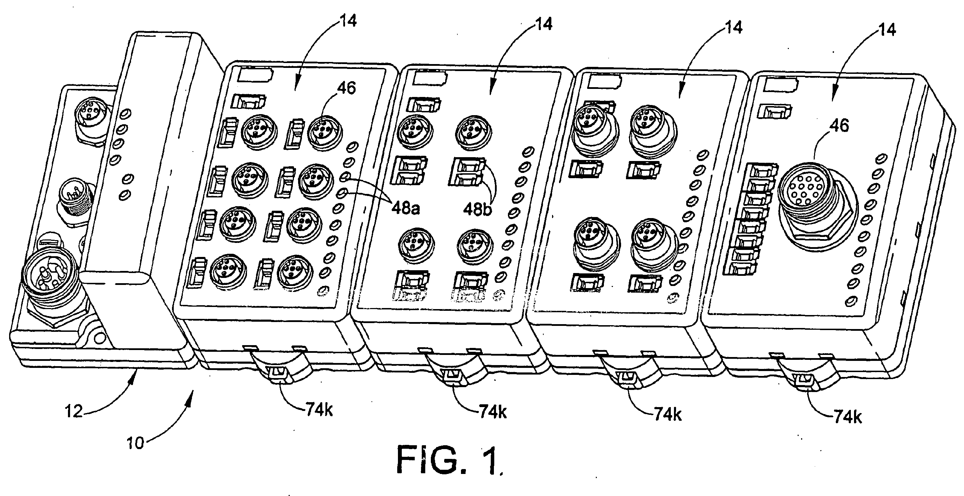

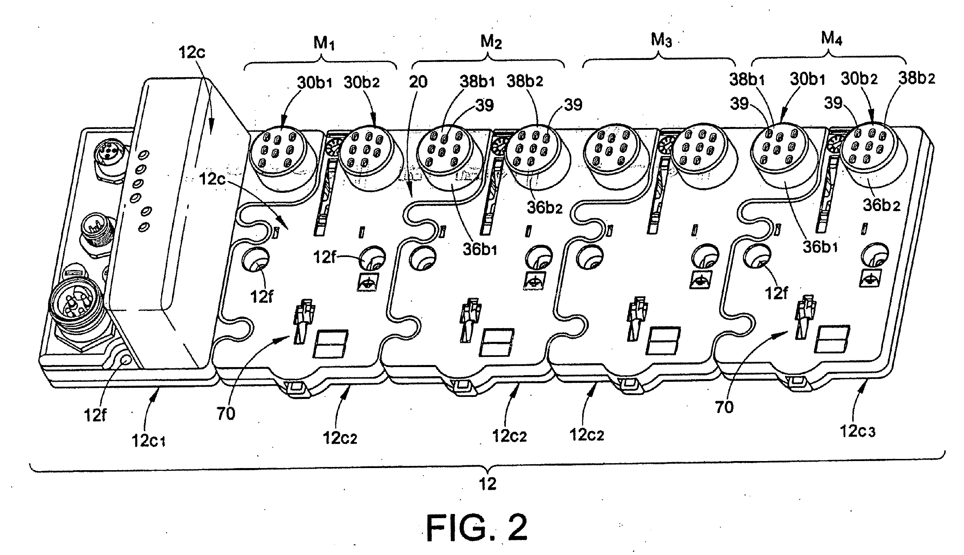

FIG. 1 illustrates a modular electrical device **10** in accordance with the present development. The device **10** comprises a modular base assembly **12** and one or more removable modules **14.** The modules **14** are releasably connected to the base assembly **12** and can be selectively removed to reveal the underlying base assembly **12** as shown in FIG. 2. The device **10** can be electrically configured to perform any of a wide variety of functions, and it is not intended that the development as described herein be limited to any particular electrical function. For ease of explaining the development **10,** however, reference is made herein to use of the device **10** as a distributed modular input/output (I/O) assembly as used, e.g., as part of an industrial automation control system.

FIG. 2 shows that the base assembly **12** comprises a plurality of modular base components **12c** (i.e., more than one) arranged adjacent each other, preferably mechanically interconnected with each other, so as to define a field bus or backplane **20.** The backplane **20** defines a plurality of module mounting locations such as the four mounting locations **M1** - **M4** shown in FIG. 2. As is described in full detail below, each mounting location is adapted to receive and releasably retain one of the removable modules **14.**

In a typical installation, the base assembly **12** is defined by a single adapter base component **12c1,** one or more intermediate base components **12c2** and a single end base component **12c3.** The number of intermediate base components **12c2** is varied to control the number of mounting locations **M1-M4** defined by the backplane **20.**

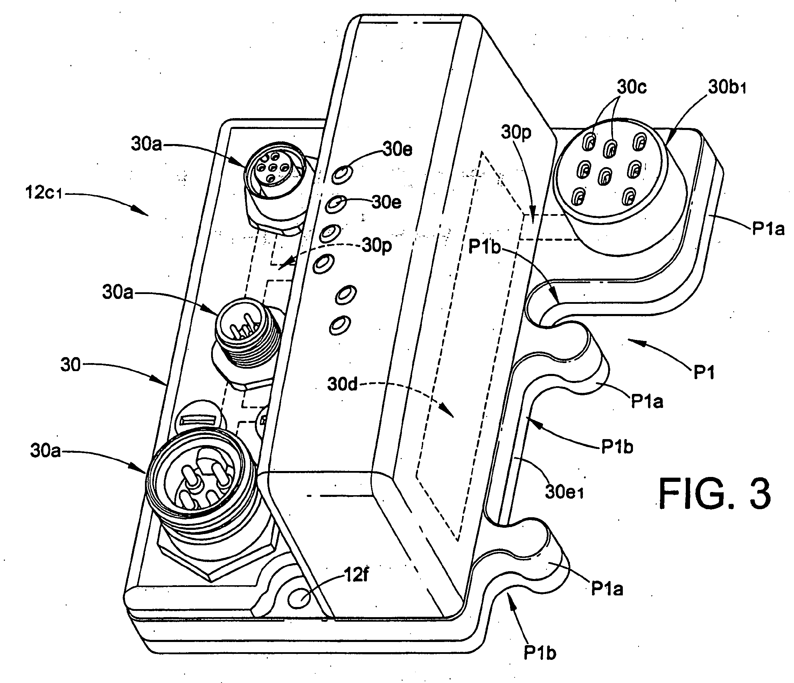

An adapter base component **12c1** is shown separately in FIG. 3 and comprises a body **30** to which network (e.g., data/power) connectors **30a** are affixed. The network connectors **30a** are conventional and provide input and/or output of electrical power and data to/from an external network. The adapter base component **12c1** further comprises a first base connector **30b1** including one or more contacts **30c** which can comprise, e.g., male or female contacts. The base connector **30b1** is shown as a male plug connector with female contacts **30c,** but could also be a female socket connector with male pin contacts. The network connectors **30a** and contacts **30c** are electrically connected to electronic circuitry **30d** housed within the body **30** as shown by paths **30p.** LED's or other visual output devices **30e** are connected to and/or form part of the circuitry and provide visual output on the status of the circuitry **30d.**

The network connectors **30a** provide for input and output of power and/or data between the circuitry **30d** and other portions of the modular electrical device **10** and an external network, as controlled by the electronic circuitry **30d,** while the first base connector **30b1** and contacts **30c** thereof provide for input and output of data and/or power between the adapter base component **12c1** and other portions of the device **10,** such as the intermediate base component(s) **12c2** and end base component **12c3** of the base assembly **12,** and the removable modules **14** connected thereto. In one example, the modular electrical device **10** is provided as a distributed I/O assembly for an industrial automation network, and the network connectors **30a** and circuitry **30d** are configured to connect and communicate with the external automation network. The electronic circuitry **30d** and, except for the accessible mating portions, the network connectors **30a** and contacts **30c,** are sealed within the body by potting compound or other means to protect against environmental contamination.

The body **30** of the adapter base component **12c1** comprises a first puzzle-piece connector structure **P1** defined by a first peripheral edge **30e1.** The first puzzle-piece connector structure **P1** comprises one or more male projections **P1a** and female recesses **P1b.** The first base connector **30b1** is located on one of the male projections **P1a.**

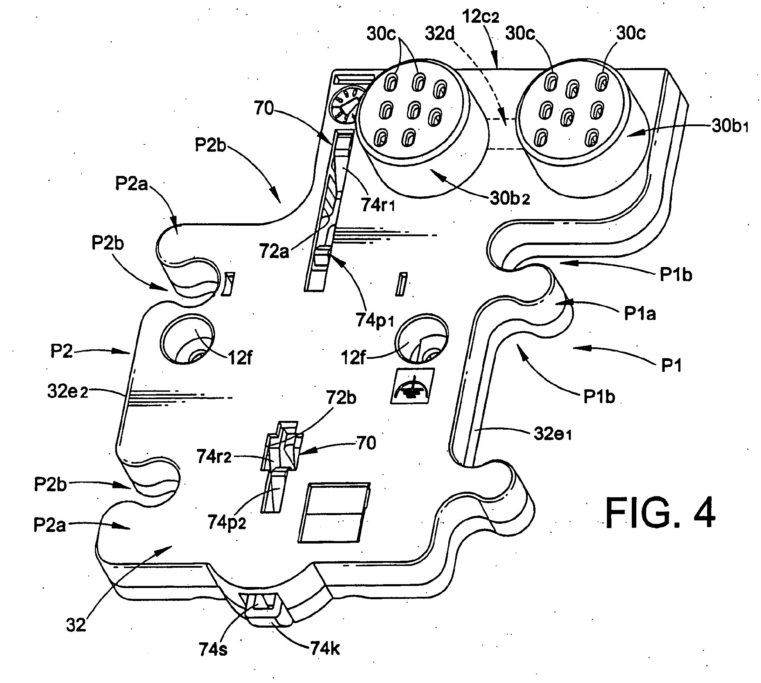

Figure 4 illustrates an intermediate base component **12c2.** The intermediate base component comprises a body **32** which includes both first and second base connectors **30b1,30b2** each including one or more contacts **30c** which can comprise, e.g., male or female contacts. The base connectors **30b1,30b2** can be male (plug) connectors (as shown) or female (socket) connectors. Each contact **30c** of the first base connector **30b1** is electrically coupled to a corresponding contact **30c** of the second base connector **30b2** by conductor bars **32d** or the like which are sealed in the body **32** by potting compound or other means.

The body **32** of component **12c2** comprises a first peripheral edge **32e1** that also defines the first puzzle-piece connector structure **P1** described above. The body **32** further comprises a second peripheral edge **32e2,** located opposite the first peripheral edge, that defines a second puzzle-piece connector structure **P2** that includes one or more male projections **P2a** and female recesses **P2b** that are conformed to mate closely with corresponding male/female structures **P1a,P1b** of the first puzzle-piece structure **P1** in only a single possible position. As such, the second puzzle-piece structure **P2** of an intermediate base component **12c2** is mated with the first puzzle-piece structure **P1** of the adapter base component **12c1** or another intermediate base component **12c2** as shown in FIG. 2.

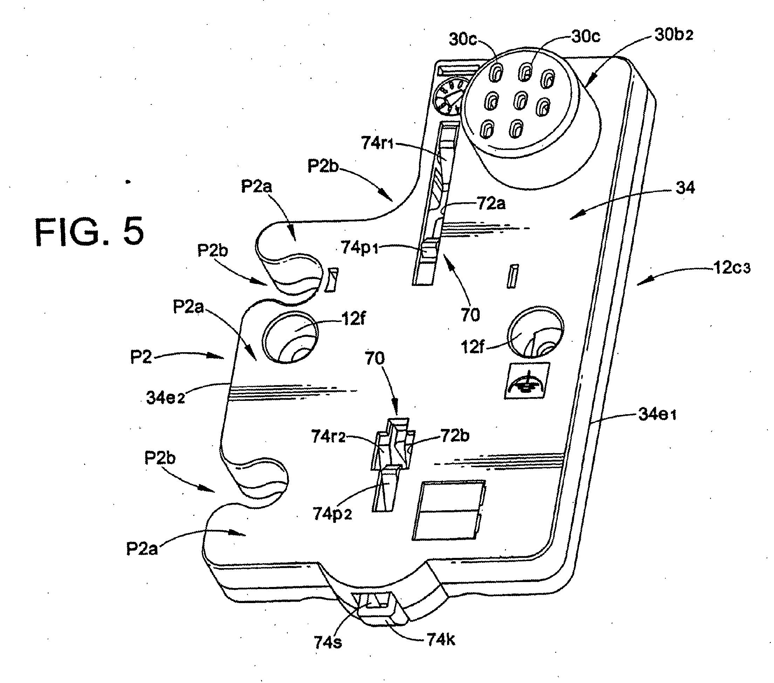

Figure 5 illustrates an end base component **12c3.** The end base component comprises a body **34** which includes only a second base connector **30b2** having one or more contacts 30c which can comprise, e.g., male or female contacts. The base connector **30b2** can be male (plug) connector (as shown) or female (socket) connector. In certain cases, the contacts **30c** of the end base module **12c3** can be non-functional (e.g., grounded through one or more resistors or otherwise) because they are located at the terminal end of the backplane **20.**

The body **34** comprises a first peripheral edge **34e1** that is non-functional and further comprises a second peripheral edge **32e2,** located opposite the first peripheral edge, that defines the second puzzle-piece connector structure **P2** as described above, including the one or more male projections **P2a** and female recesses **P2b** that are conformed to mate precisely and in only one possible position with corresponding male/female structures **P1a,P1b** of the first puzzle-piece structure **P1.** As such, the second puzzle-piece structure **P2** of the end base component **12c3** is mated with the first puzzle-piece structure **P1** of the adapter base component **12c1** or an intermediate base component **12c2** as shown in FIG. 2.

Referring again to FIG. 2, it can be seen that when the backplane **20** is constructed by the adapter base component **12c1**, at least one intermediate base component **12c2** and an end base component **12c3,** the mounting locations **M1-M4** each comprises a corresponding pair of base connectors **30b1,30b2,** i.e., a first base connector **30b1** from a first base component **12c** and a second base connector **30b2** from a second, adjacent base component **12c.** The backplane **20** can alternatively comprise only the adapter base component **12c1** and the end base component **12c3** so as to comprise only a single mounting location. Corresponding pairs of base connectors **30b1,30b2** defining each mounting location **M1-M4** are electrically connected only through the removable modules **14,** when the modules are mated to the backplane **20.** The various mating puzzle-piece structures **P1,P2** mechanically interconnect the base components **12c1,12c2,12c3,** and ensure proper spacing and alignment of the corresponding pairs of base connectors **30b1,30b2** to define the mounting locations **M1-M4** to allow for releasable mating of a module **14.** Each base component **12c1,12c2,12c3** includes at least one aperture or other fastener-receiving location **12f** adapted to receive a screw, rivet, clip, pin or other fastener or fastening means for fixedly securing the base component **12c1,12c2,12c3** to a support surface.

With reference again to FIG. 2, the base connectors **30b1,30b2** include outer surfaces **36b1,36b2** and transverse end walls **38b1,38b2**, respectively. As shown, the base connectors **30b1,30b2** are frusto-conical in shape, with the outer surfaces **36b1,36b2** converging slightly (e.g., at a 1 degree angle) moving toward the transverse end walls **38b1,38b2,** but the outer surfaces **36b1,36b2** can also be purely cylindrical or otherwise shaped. The frusto-conical shape is thought to facilitate sealing and unsealing between the connectors **30b1,30b1** and a module **14** mated therewith as described below. The end walls **38b1,38b2** define apertures **39,** and the contacts **30c** are located within these apertures (for female contacts as shown) or project through these apertures (for male contacts).

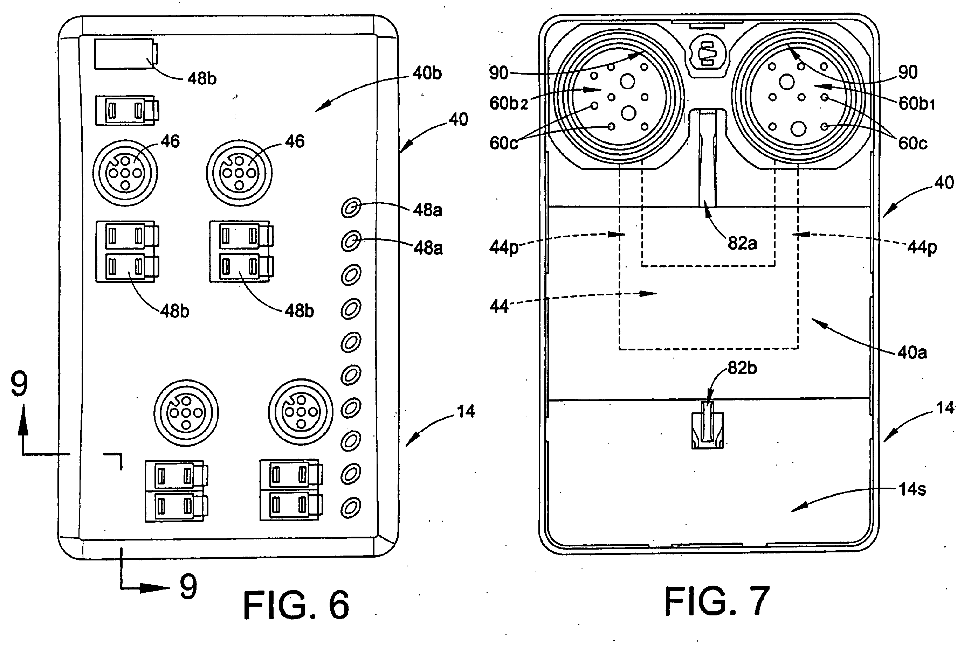

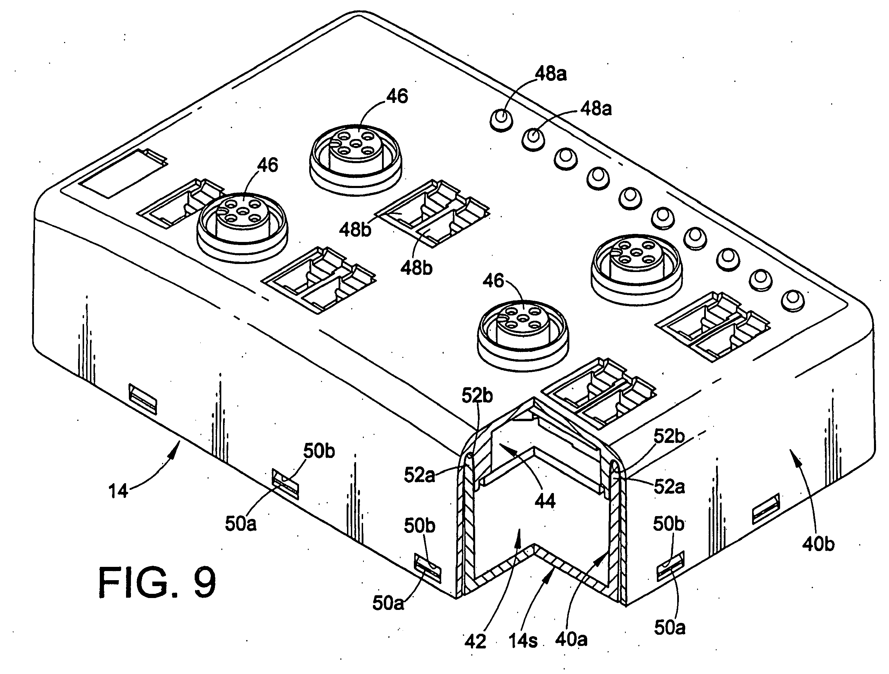

FIGS. 6-9 illustrate one example of a removable module **14** formed in accordance with the present development. Each module **14** comprises a housing **40** constructed from inner and outer housing members **40a,40b** that are inter-fitted with each other to define an enclosed interior space **42** (FIG. 9) in which electronic circuitry **44** is located.

A plurality of connectors **46** are operably connected to the circuitry **44** and project through the outer housing member **40b** so as to be adapted for mating with corresponding cable connectors from external devices. The circuitry and connectors **44,46** are adapted for any desired electrical application. In one example, each module **14** performs as an industrial automation I/O module to which field devices and the like are connected via connectors **46,** and the circuitry **44** is configured for this purpose. FIG. 1 shows a plurality of differently configured removable modules **14** including different types and arrangements of circuitry **44** and connectors **46.** Regardless of the configuration, modules **14** typically comprises a visual indicators such as LED's **48a** that provide visual output signals concerning the state of the circuitry **44** and marker holders **48b** used for labeling connectors **46** or for other purposes.

The housing **40** is sealed against ingress of environmental contaminants. The circuitry **44** and connectors **46** are potted within the outer housing member **40b** or otherwise sealed in place. The inner housing member **40a** is then sealed within the outer housing member, preferably by both mechanical and adhesive means, to provide the sealed interior space **42.** With reference to the sectional view of FIG. 9, it can be seen that the inner housing member **40a** is adapted for nesting within the outer housing member **40b** and comprises a plurality of tabs **50a** that are received in corresponding recesses **50b** such as notches, or apertures defined by the outer housing member **40b** so that the housing members **40a,40b** are mechanically interlocked with a close snap-fit. The tabs **50a** can alternatively project from the outer housing **40b** and the recesses **50b** can be defined in the inner housing **40a.** Furthermore, the inner housing member **40a** comprises a continuous wall **52a** projecting outwardly therefrom that is received within a corresponding continuously extending groove **52b** defined by the outer housing member **40b.** The joint at the junction of the wall **52a** and groove **52b** is sealed with a gasket or, preferably, with an adhesive and/or sealant such as, e.g., epoxy.

The housings **30,32,34** of the base components **12c1,12c2,12c3** and the inner and outer housing members **40a,40b** of the removable modules **14** are preferably defined as molded polymeric constructions utilizing any of a wide variety of polymeric materials in an injection molding process. One suitable material is glass-filled polyester, although it is not intended that the development be limited to such material or any other material.

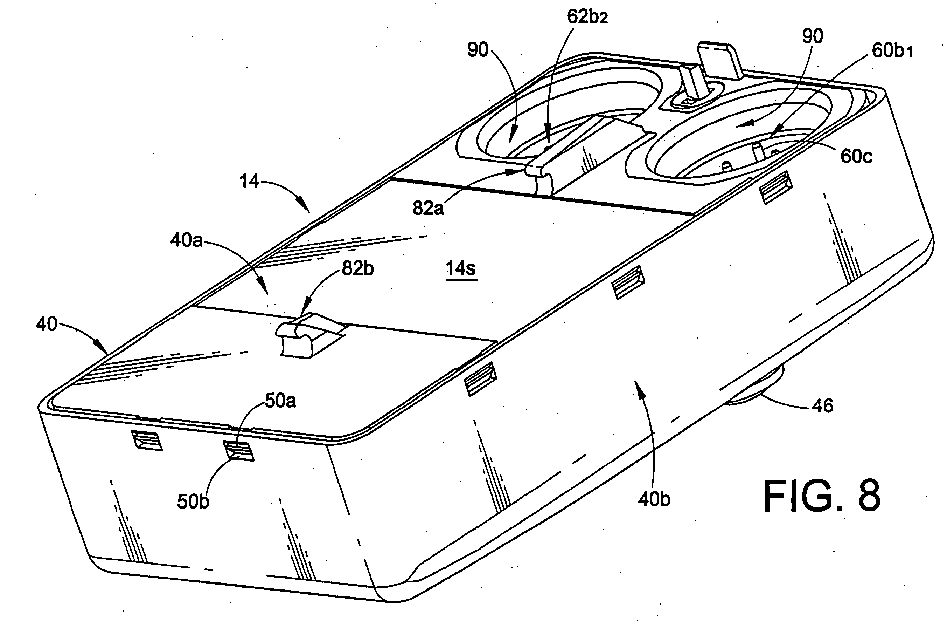

As noted above, each module **14** is adapted for releasable connection to the backplane **20** of the base assembly **12.** To this end, each releasable module **14** comprises first and second module connectors **60b1,60b2** (see e.g., FIGS. 7,8) that are adapted to mate respectively with a corresponding pair of first and second base connectors **30b1,30b2** of the backplane **20** at each mounting location **M1-M4.** In the illustrated embodiment, the first and second module connectors **60b1,60b2** are female or socket connectors comprising a plurality of male (as shown) or female contacts **60c,** wherein the contacts 60c are electrically coupled to the module circuitry **44** and/or to other contacts **60c** by paths **44p** as shown in FIG. 7. Each base connector **60b1,60b2** is dimensioned and conformed for mating with a base connector **30b1,30b2** of the backplane **20,** so that the contacts **60c** mate with corresponding contacts **30c** of the base connectors **30b1,30b2** to establish electrical connection between the backplane **20** and the modules **14.** In this manner, the modules **14** act as and provide electrical links by which the individual base components **12c** are electrically interconnected to each other through their base connectors **30b1,30b2** so that data and/or power can flow from each module **14** to each other module **14,** from each base component **12c** to each other base component **12c,** and/or from each module **14** to each base component **12c,** including the adapter base component **12c1** and circuitry **30d** thereof as required for use of the device **10.**

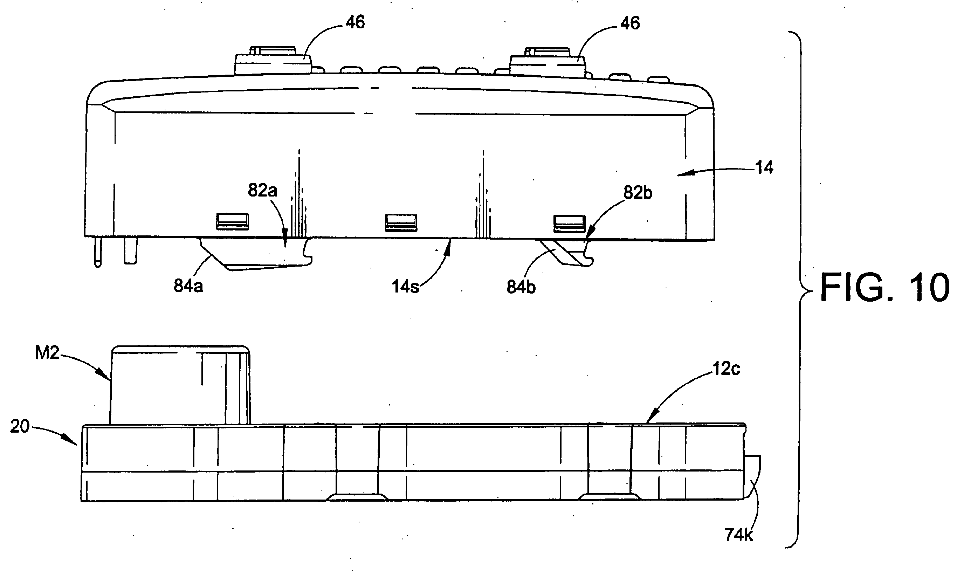

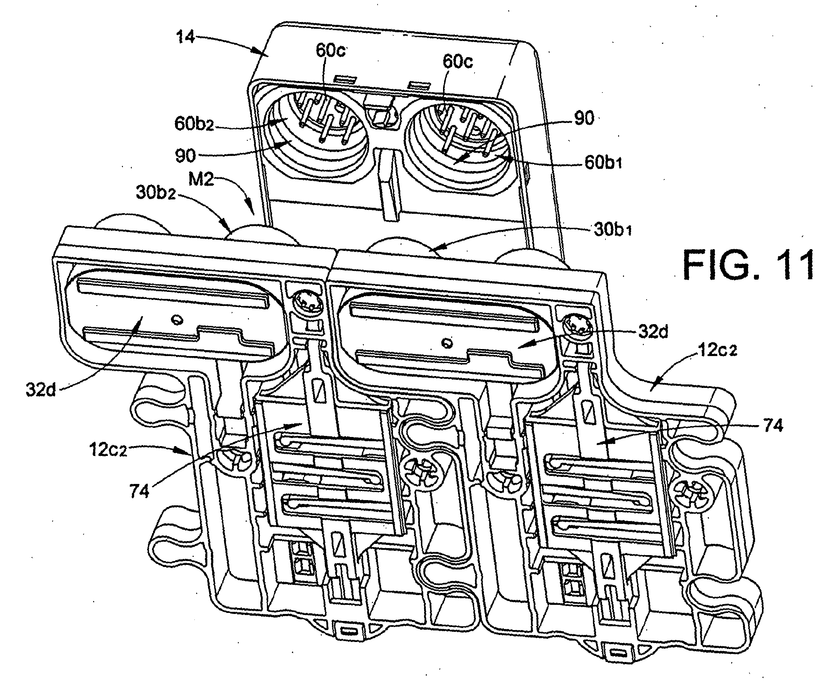

FIGS. 10 and 11 are provided to show the relationship of a removable module **14** to the backplane **20** of base components **12c** as the removable module is about to be connected to the backplane. There, it can be seen that the mounting location **M2** of the backplane 20 is defined by base connectors **30b1,30b2** of interlocked base components **12c2.** The connectors **60b1,60b2** of removable module **14** are adapted to mate with the base connectors **30b1,30b2,** respectively, so that module spans the base connectors **30b1,30b2.** Of course, the electrical conductors **32d** of each base component **12c2** interconnect each of the base connectors **30b1,30b2** of the mounting location **M2** to the other base connector **30b2,30b1** on the same base component.

When a removable module **14** is operatively mated to the backplane **20** as shown in FIG. 1, it is releasably interlocked to one of the base components **12c** to prevent unintended separation of the module **14** from the backplane **20** by gravity, vibration, impact, vandalism, cable stresses and/or other external forces. FIGS. 2, 4 and 5 illustrate that each intermediate base component **12c2** and the end base component **12c3** comprises a coupling device **70** adapted to receive and retain a portion of a removable module **14** to connect the module to the base component **12c2,12c3** to prevent unintended disconnection. FIGS. 7, 8 and 10 clearly show that each module **14** comprises at least one and, preferably, at least two coupling projections such as spaced-apart hooks **82a,82b** that project outwardly from an inner surface **14s** thereof (the inner surface **14s** is defined as the surface of module **14** that contacts and/or is located adjacent the backplane **20** when the module **14** is mated to the backplane). These first and second hooks **82a,82b** are received into first and second slots **72a,72b** (FIGS. 4,5) of the base component housing **32,34** and are retained by the coupling device **70** when the module **14** is operatively connected to the backplane **20.**

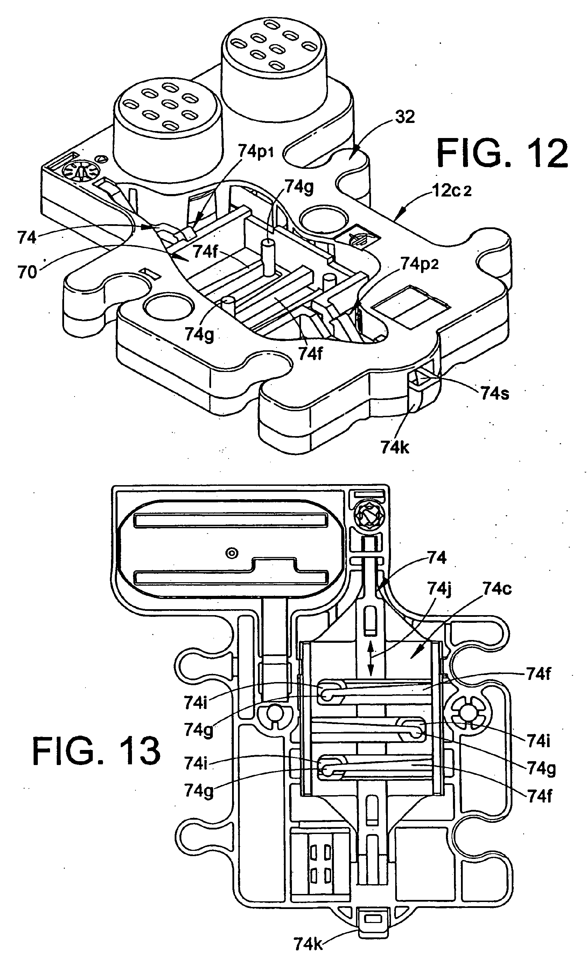

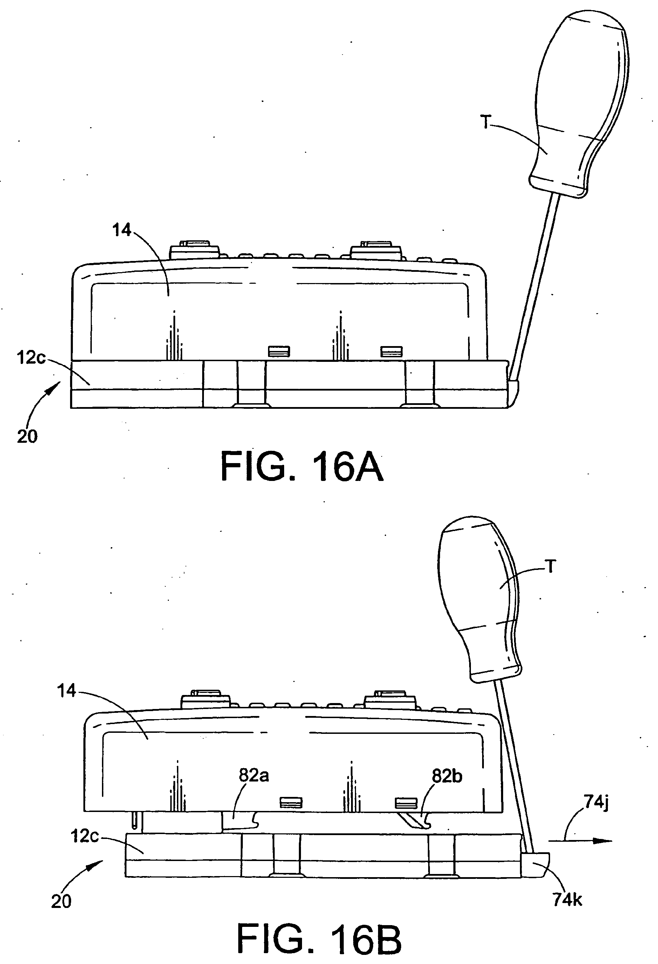

The structure and operation of the coupling device **70** and use of same to operably couple a module **14** to the backplane **20** is explained further with reference to FIGS. 12- 16B, using an intermediate base component **12c2** as an example. Those of ordinary skill in the art will recognize that the coupling device **70** of an end base module **12c3** is structured and functions identically. In FIG. 12, portions of the housing **32** are broken away to reveal the coupling device **70.** The coupling device **70** comprises a lock member **74** that is slidably connected to the housing **32** and adapted for reciprocating sliding movement between a first or "locked" position (FIGS. 12,16A) and a second or "release" position (FIG. 16B). The lock member **74** is preferably spring-biased into the first position.

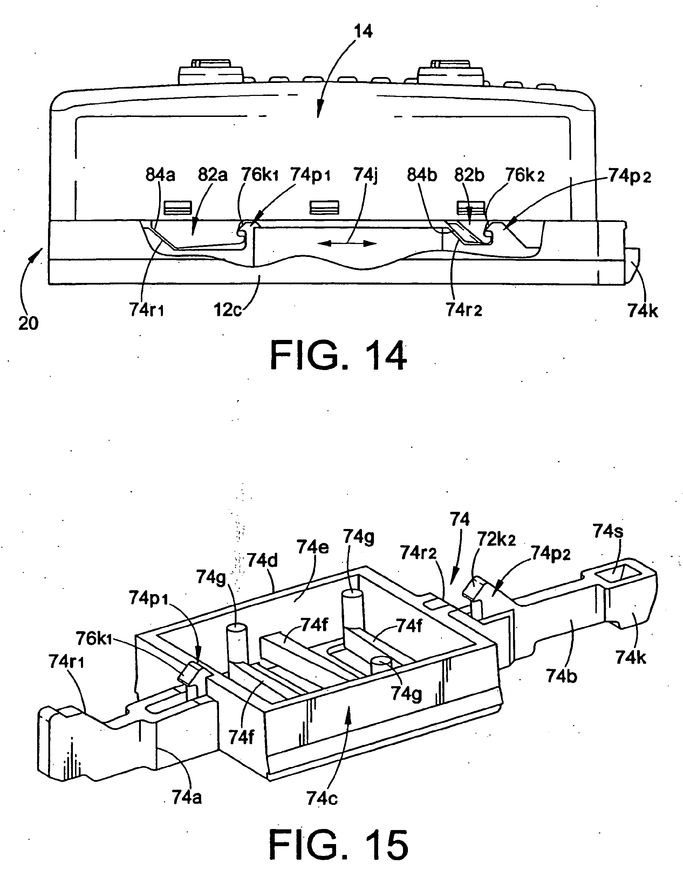

FIG. 15 shows the lock member **74** by itself. In the illustrated embodiment, the lock member comprises a one-piece molded polymeric construction comprising first and second ends **74a,74b** separated from each other by a spring portion **74c.** The spring-biasing can be supplied by a separate spring or other resilient element but, in the illustrated embodiment, the biasing is provided by the spring portion **74c** that is defined as a part of the one-piece molded plastic lock member. One suitable polymeric material for molding the lock member is acetal, although other materials are contemplated and can be used. It is not intended that the development be limited to a one-piece molded polymeric lock member, and the lock member can be defined from other materials and/or fabricated from multiple pieces, and the term "member" as used herein is not intended to be limited to a one-piece structure.

In the example shown herein, the spring portion **74c** comprises a frame **74d** that defines an open space **74e.** At least one and, preferably, a plurallity of fingers **74f** project from the frame **74d** into the space and terminate in free distal ends comprising feet **74g** defined in the form of a post or other structure. With reference now to FIGS. 12 and 13, the feet **74g** are engaged with bosses **74i** or other portions of the body **32** of the base component **12c** so as to be restrained against sliding movement with other portions of the lock member **74.** Except for the feet **74g,** the lock member **74** is slidably movable relative to the body **32** of the base component **12c** between the first and second positions as indicated by the arrow **74j,** by exertion of force on the actuator portion **74k** of the lock member that projects outwardly away from the housing **32.** Thus, when the actuator **74k** is pulled outwardly away from the housing (FIG. 16B), the lock member **74** slides from its normal first position to its second "release" position, while the fingers **74f** resiliently deflect owing to the immovable engagement of the feet **74g** with the body **32** of the base component **12c.** Upon release of the actuator **74k,** the natural resilience of the fingers **74f** returns them to their original shape or "home" position as shown in FIGS. 12 and 13 so as to move the lock member **74** back to its first "locked" position.

The lock member **74** comprises first and second latch portions **74p1,74p2** that are conformed and dimensioned and otherwise adapted to receive and retain the respective first and second hooks or other projections **82a,82b** of the module **14.** The first and second latch portions **74p1,74p2** are located respectively in the slots **72a,72b** of the base component housings **32,34.**

FIG. 14 shows a module **14** operatively mated to the backplane **20** in a mounting location **M1-M4,** with the coupling projections **82a,82b** thereof mated with and retained by the first and second latch portions **74p1,74p2**, respectively. The first and second latch portions are adapted to mate with the first and second hooks **82a,82b** and thus comprise hook-like structures oriented oppositely relative to the hooks **82a,82b** of the modules **14.** The first and second latch portions **74p1,74p2** are each defined with a sloped outer surface **76k1,76k2** oriented and located so that, during installation of a module **14** to the backplane **20,** the projections **82a,82b** of the module engage the sloped surfaces **76k1, 76k2** and urge the lock member **74** out of its natural first position toward its second position until the module **14** is fully seated against the backplane **20,** at which time the spring portion **74c** of the lock member **74** biases the lock member back to its first position so that the latch members **74p1,74p2** engage the hooks **82a,82b,** respectively, with a snap-fit so that a user received tactile feedback of full and proper installation of the module **14** to the backplane **20.**

As shown in FIG. 14, when a removable module **14** is fully operatively seated against a component **12c** of the backplane **20,** the first and second hooks **82a,82b** thereof are engaged with the first and second latch members **74p1,74p2.** The lock member **74** also functions as a module ejector and, thus, comprises one or more ejection surfaces such as the first and second ejection ramps **74r1,74r2** (see also FIGS. 4,5) conformed and arranged to engage the first and second hooks **82a,82b** or another part of the module **14** when the lock member **74** is moved toward and into its second operative position. In the illustrated embodiment, the module coupling hooks **82a,82b** comprise respective ejection surfaces **84a,84b** (see FIGS. 10,14) that lie adjacent the ejection ramps **74r1,74r2**. It is preferred that the ejection surfaces **84a,84b** and ejection ramps **74r1,74r2** be conformed as smooth mating sloped ramp surfaces.

With reference now to FIG. 14 and also FIGS. 16A and 16B, when the lock member is moved from its first or "locked" position (FIGS. 14,16A) to its second or "release" position (FIG. 16B), the latch portions **74p1,74p2** disengage from hooks **82a,82b** to allow for separation of the module **14** from the backplane. At the same time, the first and second ramp surfaces **74r1,74r2** of the lock member **74** slidably bear against the ejection surfaces **84a,84b** of the module **14** and displace the module outwardly away from the backplane **20** to a position where it will be freely separable from the backplane (even if the lock member **74** is again released and allowed to return to its normal locked position before the module is lifted away from the backplane). The actuator portion **74k** of the lock member **74** is preferably defined with a recess **74s** that is adapted to receive a screw-driver blade or other tool **T** as shown in FIGS. 16A and 16B to facilitate movement of the lock member **74** from its locked position to its unlocked position as shown.

The device **10** comprises a seal associated with each mated pair of a base connector **30b1,30b2** with a module connector **60b1,60b2** to sealingly engage these connectors and prevent contamination of the contacts **30c,60c.** FIGS. 7, 8 and 11 illustrate one embodiment of a seal formed in accordance with the present development, wherein a seal **90** is associated with each module connector **60b1,60b2.** When the module connectors **60b1,60b2** are female socket-type connectors as shown, the seal **90** is located within the socket of the connector as shown. In this manner, when a module **14** is removed from the backplane **20** and replaced with a new module, the new module is supplied with a new seal **90.**

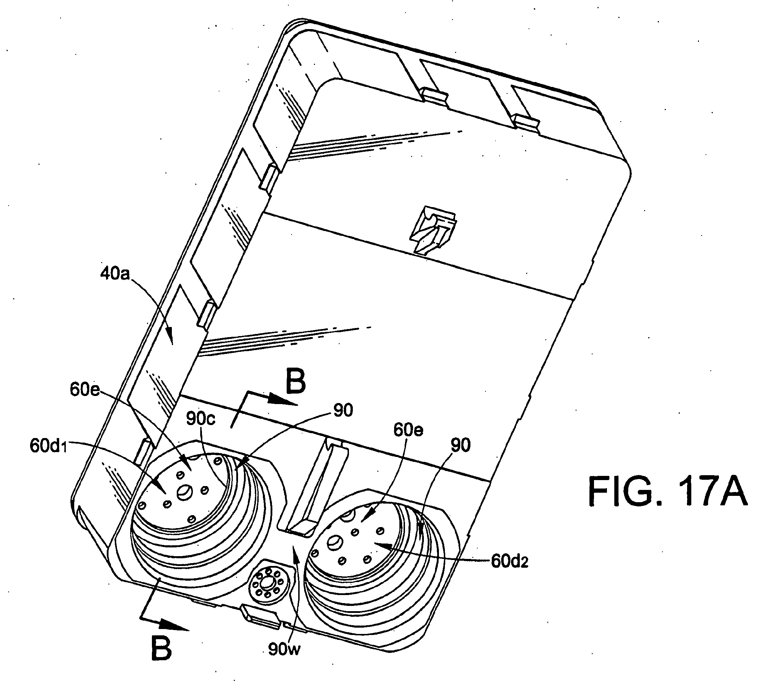

The seal **90** is explained with reference to FIGS. 17A-17C. As noted, a seal **90** is associated with each connector **60b1,60b2** of each module **14.** FIGS. 17A shows an inner housing **40a** of a module **14** and first and second seals **90** connected thereto (the male pin contacts **60c** are not shown). The seals **90** are recessed within first and second connector sockets **60d1,60d2** of the housing **40b.**

The seals 90 are each preferable defined as a one-piece molded polymeric construction using any suitable elastomeric or other resilient polymeric material (as shown the two seals **90** are also defined as a one-piece construction with each other and are interconnected by a web **90w).** In one embodiment, each seal **90** is defined as a one-piece molded construction from a thermoplastic elastomer (TPE) such as SANTOPRENE^{®} brand TPE, but it is not intended that the development be limited to this material. It is possible for the seals **90** to be molded or otherwise constructed separately from the inner housing member **40a,** and then installed into the connector sockets **60d1,60d2** so as to be retained by a friction-fit, adhesive and/or other means. It is deemed preferable, however, to utilize a two-step injection molding process: (i) a first step to mold the inner housing **40a,** including the sockets **60d1,60d2;** and, (ii) a second step to mold the seals **90** directly into the sockets **60d1,60d2.** This method reduces labor costs and is believed to result in a better connection of the seal **90** to the housing **40a.**

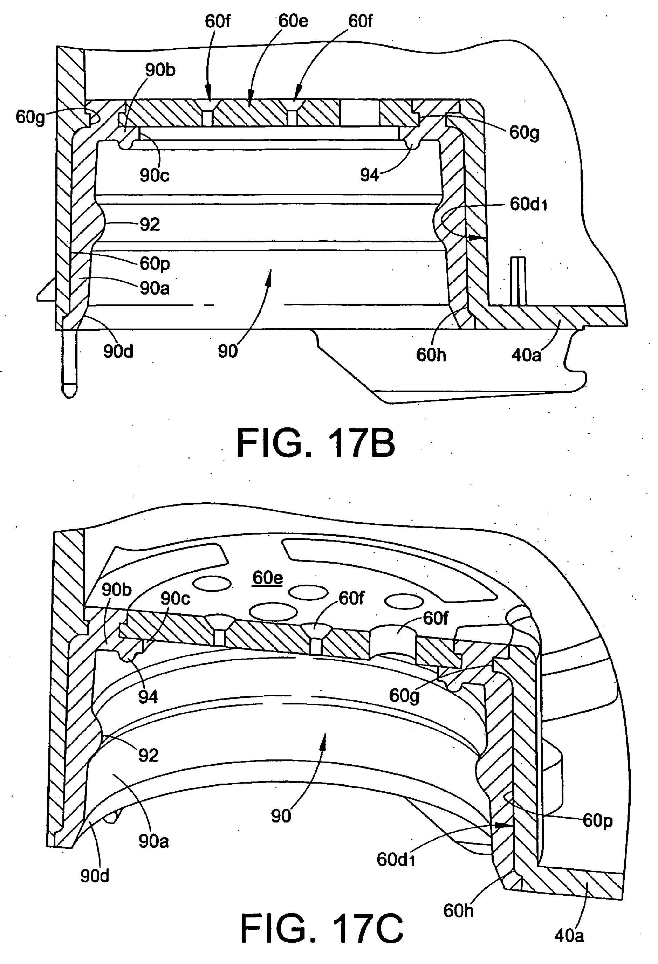

FIGS. 17B and 17C are sectional views that show one embodiment for the seal **90** and connection of same to the socket **60d1** (the seal **90** is connected to the socket **60d2** in a corresponding fashion). The socket **60d1** comprises an inner transverse wall **60e** through which a plurality of apertures **60f** are defined to allow for installation of contacts **60c** such as the male pins shown in FIG. 11 and elsewhere. The peripheral wall **60p** of socket **60d1** is generally cylindrical, and the seal **90** comprises a correspondingly generally cylindrical peripheral wall portion **90a** that is closely conformed to the socket **60d1.** The seal **90** also comprises an annular inner wall **90b** arranged transverse to the cylindrical portion **90a** and abutted with the inner wall **60e** of socket **60d1.** The annular inner wall **90b** of seal **90** defines a central opening **90c** that is aligned with the portion of the inner wall **60e** in which the apertures **60f** are defined to ensure that the seal **90** does not obstruct the apertures **60f.** The result of this structure is that the seal **90** has a generally L-shaped cross-section. If desired, the inner wall **90b** of seal can completely cover the inner wall **60e** of the socket and include apertures defined therein that are registered with the apertures **60f** of the socket inner wall **60e.** The outer end **90d** of seal **90** preferably diverges moving out of the socket **60d1** to facilitate insertion of a base connector **30b1,30b2.**

The inner wall **60e** of the socket **60d1** also defines flow passages **60g** and, during the two-step molding operation, the material from which the seal is defined flows through these passages **60g** and then cures, with the result being that the seal **90** is mechanically interlocked with the socket **60d1** and anchored therein. Depending upon the particular materials from which the seal **90** and housing **40a** are molded, the seal **90** can also be adhered to the socket **60d** and/or chemically bonded thereto as a result of the two-step molding operation.

The seal **90** comprises at least one and preferably at least two sealing elements that provide two different, transverse sealing dynamics. As shown, the seal comprises a radial sealing element for sealingly engaging radially or laterally adjacent surfaces and an axial (compressive) sealing element for sealingly engaging axially adjacent surfaces.

The radial sealing element comprises at least one continuous radial lip **92** that projects radially inward from the peripheral wall portion **90a** toward a central region of the socket **60d1.** The one or more radial lips **92** are adapted to abut and sealingly engage the outer cylindrical or conical surfaces **36b1,36b2** (FIG. 2) of an associated base connector **30b1,30b2** inserted in the socket **60d1.** If the associated base connector **30b1,30b2** is frusto-conical as described above, it has been found to facilitate insertion and removal of the base connector **30b1,30b2** relative to the socket **60d1** without compromising the effectiveness of the radial sealing element **92.**

The axial sealing element comprises at least one continuous axial lip **94** that projects axially outward from the inner wall **90b** of the seal **90** into the socket **60d1** toward the entrance **60h** of the socket. The one or more the axial lips **94** are adapted to abut and sealingly engage the transverse end wall **38a,38b** (FIG. 2) of an associated connector **30b1,30b2** inserted into the socket **60d1.**

The combined radial and axial sealing has been found to be highly effective. The effectiveness of the radial and axial sealing elements are enhanced owing to the use of the coupler **70** for coupling the removable modules **14** to the backplane **20** to ensure good and continuous engagement of the radial seal element **92** with connector surfaces **36b1,36b2** and the axial seal element **94** with connector surfaces **38b1,38b2,** respectively. Furthermore, the module ejection function of the coupler **70** that displaces the module **14** away from the backplane **20** as described above helps to overcome the sealing engagement between the module **14** and the backplane **20** established by seal **90** that can otherwise hinder separation of a module **14** from backplane **20.**

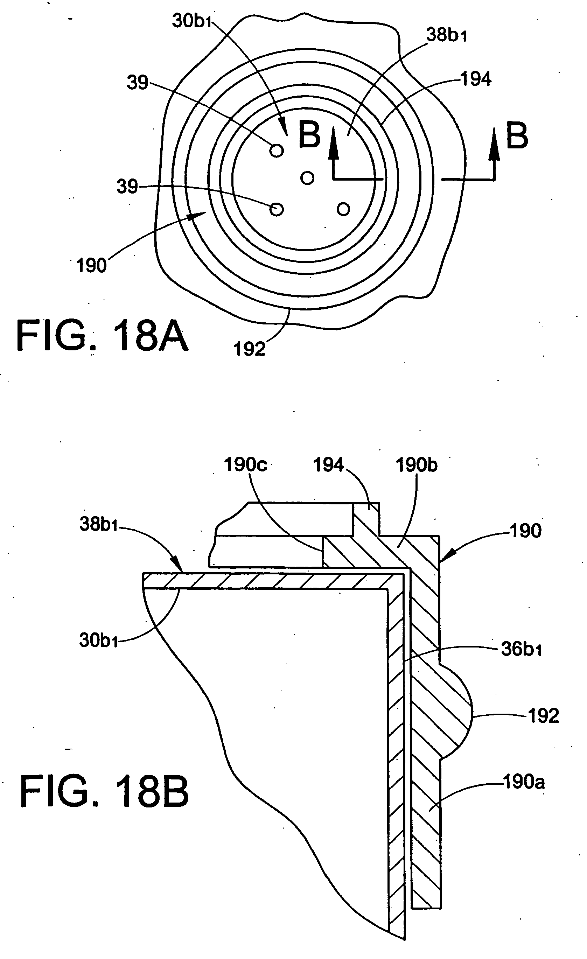

FIGS. 18A,18B illustrate an alternative embodiment where a seal **190** is connected to a base connector **30b1** instead of being located in a socket **60d1,60d2** of module **14** (the same arrangement can be applied to a base connector **30b2).** The seal **190** is similar to the seal **90** in that it comprises a first portion **190a** that is closely conformed to and covers at least part of the outer surface 36b1 of the connector. The seal **190** also comprises an annular outer wall **190b** arranged transverse to the first portion **190a** and abutted with the outer transverse wall **38b1** of the connector **30b1.** The annular outer wall **190b** of seal **190** defines a central opening **190c** that is aligned with the portion of the outer transverse wall **38b1** in which the apertures **39** are defined to ensure that the seal **190** does not obstruct the apertures **39.** The result of this structure is that the seal **190** has a generally L-shaped cross-section. If desired, the inner wall **190b** of seal can completely cover the transverse wall **38b1** of the connector **30b1** and include apertures defined therein that are registered with the apertures **39.**

The seal **190** comprises at least one and preferably at least two sealing elements that act in transverse directions relative to each other. As shown, the seal comprises a radial (lateral) sealing element and an axial (compressive) sealing element.

The radial sealing element comprises at least one continuous radial lip **192** that projects radially outward from the seal first portion **190a**. The one or more radial lips **192** are adapted to abut and sealingly engage an inner surface of the socket **60d1** in which the base connector **30b1** is inserted.

The axial sealing element comprises at least one continuous axial lip **194** that projects axially outward from the outer wall **190b** of the seal **190.** The one or more axial lips **194** are adapted to abut and sealingly engage the inner wall **60e** (FIG. 2) of socket **60d1** when the base connector **30b1** is inserted into the socket.

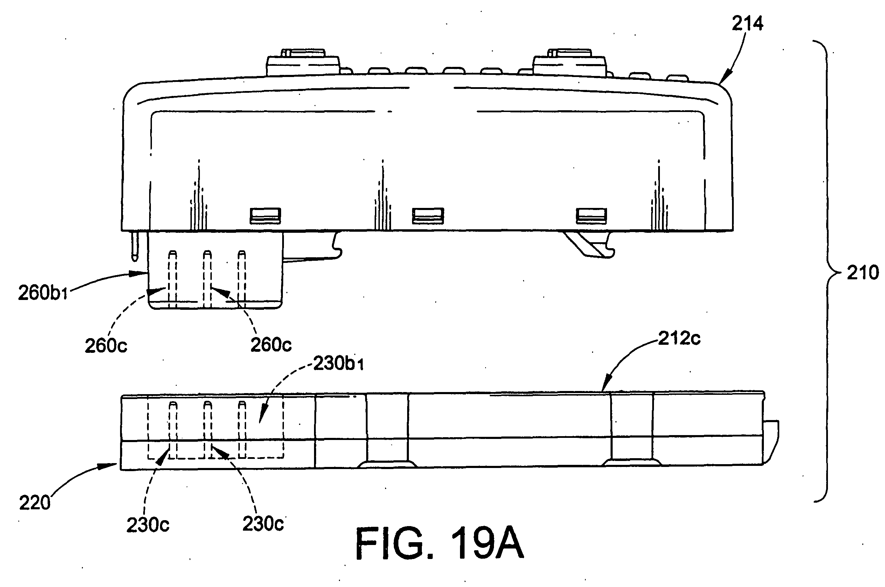

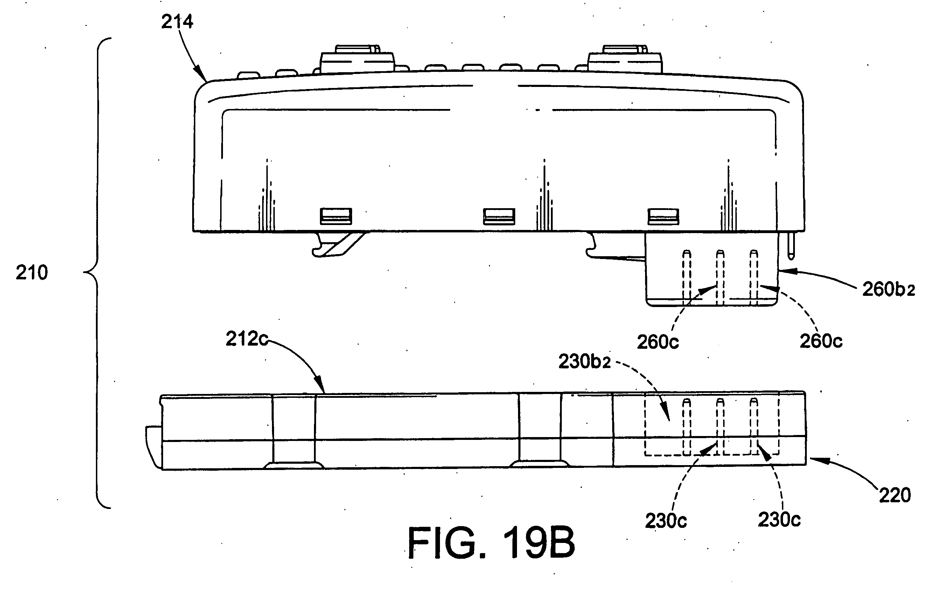

FIGS. 19A and 19B illustrate an alternative device **210** that is identical in all respects to the device **10,** except as otherwise shown and/or described. Like components relative to the device **10** are identified with like reference numerals that are **200** greater than those used in connection with the device **10.** The device **210** comprises a backplane **220** that is identical to the backplane **20** except that the base connectors **230b1,230b2** are female socket connectors comprising male pin contacts **230c.** Modules **214** are adapted for releasable connection to the backplane **220** as described above for the modules **14,** except that the module connectors **260b1,260b2** are male plug connectors including female contacts **260c.** The device **210** comprises either seals **90** located in the sockets **230b1,230b2** or seals **190** connected to the plug connectors **260b1,260b2.**

The invention has been described with reference to preferred embodiments.

## Claims

1. A modular electrical device comprising:
a. a base (12) comprising at least one mounting location comprising first and second electrical base connectors (30b1, 30b2);
b. a module (14) comprising a housing and first and second electrical module connectors (60b1, 60b2) that are respectively adapted for mating with said first and second electrical base connectors at respective first and second connectors interfaces;
c. first and second seals (90) located respectively at said first and second connector interfaces,
**characterized by**
d. said first and second seals (90) each comprising first and second sealing elements (92, 94) that act respectively in first and second directions that are transverse relative to each other and
e. said first and second sealing elements (92, 94) comprising first and second sealing lips (92, 94) that project outwardly in first and second directions that are transverse relative to each other.

2. The modular electrical device as set forth in claim 1, wherein said first and second seals (90), each including said first and second sealing elements (92, 94), are defined as one-piece constructions.

3. The modular electrical device as set forth in claim 1, wherein said first sealing lips (92, 94) comprise a radially projecting lip (92) and wherein said second sealing element comprises an axially projecting lip (94).

4. The modular electrical device as set forth in claim 1, wherein:
each of said first and second connector interfaces comprises: (i) laterally adjacent surfaces of said base connector and said module connector; and, (ii) axially adjacent surfaces of said base connector and said module connector;
said first sealing element (92) is located between and sealingly engages said laterally adjacent surfaces; and
said second sealing element (94) is located between and sealingly engages said axially adjacent surfaces.

5. The modular electrical device as set forth in claim 2, wherein said first and second seals (90) each comprise an L-shaped cross-section.

6. The modular electrical device as set forth in claim 1, wherein said first and second seals (90) are each fixedly secured to either said base or said module.

7. The modular electrical device as set forth in claim 6, wherein both of said first and second seals (90) are connected to said module.

8. The modular electrical device as set forth in claim 7, wherein said first and second module connectors (30b1, 30b2) comprise respective first and second female sockets, and wherein said first and second seals are located respectively in said first und second sockets.

9. The modular electrical device as set forth in claim 8, wherein said first and second seals (90) are molded into said first and second sockets.

10. The modular electrical device as set forth in claim 8, wherein said first and second seals (90) are defined together as a one-piece construction and are interconnected by a web (90w).

11. The modular electrical device as set forth in claim 9, wherein said first and second sockets (30b1, 30b2) each define flow passages, and wherein said first and second seals (90) are molded into said flow passages so as to be mechanically anchored in said first and second sockets, respectively.

12. The modular electrical device as set forth in claim 1, wherein said module comprises an outer housing (40b) and an inner housing (40a) nested within the outer housing (40b), and wherein said inner housing (40a) is both mechanically and adhesively secured to said outer housing (40b).

13. The modular electrical device as set forth in claim 12, wherein one of said inner and outer housings (40a, b) comprises projecting tabs (50a) and the other of said inner and outer housings comprises recesses (50b) that receive said projecting tabs when said inner housing is nested within the outer housing.

14. The modular electrical device as set forth in claim 12, wherein said outer housing comprises a continuously extending groove (52b) and said inner housing comprises a projecting wall (52a) that is received in said groove, wherein said projecting wall is adhesively secured in said groove.

15. The electrical module as set forth in claim 1, wherein said first and second seals (40) are each defined as a one-piece thermoplastic elastomeric construction.

16. The electrical module as set forth in claim 1, wherein said first and second connectors are female socket connectors in which said first and second seals (90) are respectively located.

17. The electrical module as set forth in claim 16, wherein said first sealing lip (92) of each of said first and second seals projects axially, and wherein said second sealing lip (94) of each of said first and second seals projects radially.

18. The electrical module as set forth in claim 17, wherein said first and second seals each comprise a L-shaped cross-section.

## Patentansprüche

1. Modulares elektrisches Gerät, das Folgendes umfasst:
a. eine Basis (12), die mindestens eine Montagestelle mit ersten und zweiten elektrischen Basissteckern (30b1, 30b2) umfasst;
b. ein Modul (14), das ein Gehäuse und erste und zweite elektrische Modulstecker (60b1, 60b2) umfasst, die jeweils geeignet sind, mit den ersten und zweiten elektrischen Basissteckern an entsprechenden ersten und zweiten Steckverbindungsschnittstellen verbunden zu werden;
c. erste und zweite Dichtungen (90), die an den ersten und zweiten Steckverbindungsschnittstellen angeordnet sind,
**dadurch gekennzeichnet, dass**
d. die erste und zweite Dichtung (90) jeweils erste und zweite Dichtelemente (92, 94) umfassen, die in ersten und zweiten Richtungen, welche quer zueinander stehen, wirksam sind, und
e. die ersten und zweiten Dichtelemente (92, 94) erste und zweite Dichtlippen (92, 94) umfassen, die in ersten und zweiten zueinander quer stehenden Richtungen auswärts vorspringen.

2. Modulares elektrisches Gerät gemäß Anspruch 1, wobei die erste und die zweite Dichtung (90), welche jeweils die ersten und zweiten Dichtelemente (92, 94) umfassen, als einstückige Konstruktionen vorgesehen sind.

3. Modulares elektrisches Gerät gemäß Anspruch 1, wobei die ersten Dichtlippen (92, 94) eine radial vorspringende Lippe (92) umfassen und wobei das zweite Dichtelement eine axial vorspringende Lippe (94) umfasst.

4. Modulares elektrisches Gerät gemäß Anspruch 1, wobei:
jede der ersten und zweiten Steckverbindungsschnittstellen Folgendes umfasst: (i) seitlich angrenzende Oberflächen des Basissteckers und des Modulsteckers; und (ii) axial angrenzende Oberflächen des Basissteckers und des Modulsteckers;
das erste Dichtelement (92) zwischen den seitlich angrenzenden Oberflächen angeordnet ist und eine Dichtverbindung zwischen diesen herstellt; und
das zweite Dichtelement (94) zwischen den axial angrenzenden Oberflächen angeordnet ist und eine Dichtverbindung zwischen diesen herstellt.

5. Modulares elektrisches Gerät gemäß Anspruch 2, wobei die erste und die zweite Dichtung (90) jeweils einen L-förmigen Querschnitt aufweisen.

6. Modulares elektrisches Gerät gemäß Anspruch 1, wobei die erste und die zweite Dichtung (90) jeweils fest an der Basis oder am Modul befestigt sind.

7. Modulares elektrisches Gerät gemäß Anspruch 6, wobei die erste und die zweite Dichtung (90) mit dem Modul verbunden sind.

8. Modulares elektrisches Gerät gemäß Anspruch 7, wobei der erste und der zweite Modulstecker (30b1, 30b2) entsprechende erste und zweite weibliche Buchsen aufweisen und wobei die erste und die zweite Dichtung in den ersten und zweiten Buchsen untergebracht sind.

9. Modulares elektrisches Gerät gemäß Anspruch 8, wobei die erste und die zweite Dichtung (90) in die erste und zweite Buchse eingeformt sind.

10. Modulares elektrisches Gerät gemäß Anspruch 8, wobei die erste und die zweite Dichtung (90) zusammen als einstückige Konstruktion definiert und mittels eines Stegs (90w) miteinander verbunden sind.

11. Modulares elektrisches Gerät gemäß Anspruch 9, wobei die erste und zweite Buchse (30b1, 30b2) jeweils Strömungsdurchgänge umfassen und wobei die erste und die zweite Dichtung (90) in die Durchgänge eingeformt sind, um auf diese Weise in der ersten bzw. zweiten Buchse mechanisch verankert zu sein.

12. Modulares elektrisches Gerät gemäß Anspruch 1, wobei das Modul ein Außengehäuse (40b) und ein im Außengehäuse (40b) eingebrachtes Innengehäuse (40a) umfasst und wobei das Innengehäuse (40a) mechanisch und durch Klebeverbindung am Außengehäuse (40b) befestigt ist.

13. Modulares elektrisches Gerät gemäß Anspruch 12, wobei eines von innerem und äußerem Gehäuse (40a, b) vorspringende Zungen (50a) und das andere von innerem und äußerem Gehäuse Ausnehmungen (50b) aufweist, in welche die vorspringenden Zungen eindringen, wenn das Innengehäuse im Außengehäuse untergebracht wird.

14. Modulares elektrisches Gerät gemäß Anspruch 12, wobei das Außengehäuse eine durchgehende Nut (52b) und das Innengehäuse eine vorspringende Wand (52a) umfasst, die in die Nut eingeführt wird, wobei die vorspringende Wand in der Nut festgeklebt wird.

15. Elektrisches Modul gemäß Anspruch 1, wobei die erste und die zweite Dichtung (40) jeweils als einstückige, thermoplastische Elastomerkonstruktion ausgeführt sind.

16. Elektrisches Modul gemäß Anspruch 1, wobei der erste und der zweite Stecker weibliche Steckbuchsen sind, in denen die erste und zweite Dichtung (90) angeordnet sind.

17. Elektrisches Modul gemäß Anspruch 16, wobei die erste Dichtlippe (92) der ersten und zweiten Dichtung axial vorspringt und wobei die zweite Dichtlippe (94) der ersten und zweiten Dichtung radial vorspringt.

18. Elektrisches Modul gemäß Anspruch 17, wobei die erste und zweite Dichtung jeweils einen L-förmigen Querschnitt umfassen.

## Revendications

1. Dispositif électrique modulaire, comprenant :
a. une base (12) comprenant au moins une position de montage comprenant des premier et second connecteurs électriques de base (30b1, 30b2) ;
b. un module (14) comprenant un boîtier et des premier et second connecteurs électriques de module (60b1, 60b2) qui sont respectivement adaptés pour coopérer avec les premier et second connecteurs électriques de base au niveau de première et seconde interfaces respectives de connecteur ;
c. des premier et second joints d'étanchéité (90) respectivement situés sur lesdites première et seconde interfaces de connecteur ;
**caractérisé par** :
d. lesdits premier et second joints d'étanchéité (90) comprenant chacun des premier et second éléments d'étanchéité (92,94) qui agissent respectivement dans des première et seconde directions qui sont transversales l'une par rapport à l'autre ; et
e. lesdits premier et second éléments d'étanchéité (92,94) comprenant des première et seconde lèvres d'étanchéité (92,94) qui se projettent vers l'extérieur selon des première et seconde directions qui sont transversales l'une par rapport à l'autre.

2. Dispositif électrique modulaire selon la revendication 1, dans lequel lesdits premier et second joints d'étanchéité (90), comprenant chacun lesdits premier et second éléments d'étanchéité (92,94), sont définis comme des structures monoblocs.

3. Dispositif électrique modulaire selon la revendication 1, dans lequel lesdites premières lèvres d'étanchéité (92, 94) comprennent une lèvre se projetant de façon radiale (92) et dans lequel ledit second élément d'étanchéité (92, 94) comprend une lèvre se projetant de façon axiale (94).

4. Dispositif électrique modulaire selon la revendication 1, dans lequel :
- chacune desdites première et seconde interfaces de connecteur comprend : (i) des surfaces adjacentes de façon latérale dudit connecteur de base et dudit connecteur de module ; et (ii) des surfaces adjacentes de façon axiale dudit connecteur de base et dudit connecteur de module ;
- ledit premier élément d'étanchéité (92) est positionné entre et coopère de façon étanche avec lesdites surfaces adjacentes de façon latérale ; et
- ledit second élément d'étanchéité (94) est positionné entre et coopère de façon étanche avec lesdites surfaces adjacentes de façon axiale.

5. Dispositif électrique modulaire selon la revendication 2, dans lequel lesdits premier et second joints d'étanchéité (90) présentent chacun une section transversale en forme de L.

6. Dispositif électrique modulaire selon la revendication 1, dans lequel lesdits premier et second joints d'étanchéité (90) sont fixés chacun, de façon fixe, soit sur ladite base, soit sur ledit module.

7. Dispositif électrique modulaire selon la revendication 6, dans lequel tous lesdits premier et second joints d'étanchéité (90) sont connectés audit module.

8. Dispositif électrique modulaire selon la revendication 7, dans lequel lesdits premier et second connecteurs électriques de module (30b1, 30b2) comprennent des première et seconde douilles femelles respectives, et dans lequel lesdits premier et second joints d'étanchéité sont respectivement positionnés dans lesdites première et seconde douilles.

9. Dispositif électrique modulaire selon la revendication 8, dans lequel lesdits premier et second joints d'étanchéité (90) sont moulés dans lesdites première et seconde douilles.

10. Dispositif électrique modulaire selon la revendication 8, dans lequel lesdits premier et second joints d'étanchéité (90) sont définis ensemble sous la forme d'une structure monobloc et sont interconnectés par une bande (90w).

11. Dispositif électrique modulaire selon la revendication 9, dans lequel lesdites première et seconde douilles (30b1, 30b2) définissent chacun des passages d'écoulement, et dans lequel lesdits premier et second joints d'étanchéité (90) sont moulés dans lesdits passages d'écoulement afin d'être respectivement ancrés, de façon mécanique, dans lesdites première et seconde douilles.

12. Dispositif électrique modulaire selon la revendication 1, dans lequel ledit module comprend un boîtier externe (40b) et un boîtier interne (40a) emboîté à l'intérieur du boîtier externe (40b), et dans lequel ledit boîtier interne (40a) est fixé, à la fois, de façon mécanique et par adhésif audit boîtier externe (40b).

13. Dispositif électrique modulaire selon la revendication 12, dans lequel un desdits boîtiers interne et externe (40a, b) comprend des languettes en projection (50a) et l'autre desdits boîtiers interne et externe comprend des creux (50b) qui reçoivent lesdites languettes en projection lorsque ledit boîtier interne est emboîté à l'intérieur du boîtier externe.

14. Dispositif électrique modulaire selon la revendication 12, dans lequel ledit boîtier externe comprend une rainure s'étendant en continu (52b) et ledit boîtier interne comprend une paroi en projection (52a) qui est reçue dans ladite rainure, dans lequel ladite paroi en projection est fixée par adhésif dans ladite rainure.

15. Module électrique selon la revendication 1, dans lequel lesdits premier et second joints d'étanchéité (40) sont définis chacun sous la forme d'une structure monobloc en élastomère thermoplastique.

16. Module électrique selon la revendication 1, dans lequel lesdits premier et second connecteurs sont des connecteurs à douille femelle dans lesquels lesdits premier et second joints d'étanchéité (90) sont respectivement positionnés.

17. Module électrique selon la revendication 16, dans lequel ladite première lèvre d'étanchéité (92) de chacun desdits premier et second joints d'étanchéité se projette de façon axiale, et dans lequel ladite seconde lèvre d'étanchéité (94) de chacun desdits premier et second joints d'étanchéité se projette de façon radiale.

18. Module électrique selon la revendication 17, dans lequel lesdits premier et second joints d'étanchéité présentent chacun une section transversale en forme de L.
